# EUROPEAN PATENT APPLICATION

(11) **EP 2 234 158 A1**
(43) Date of publication of application: **29.09.2010**
(21) Application number: 10157368.1
(22) Date of filing: 23.03.2010
(51) Int. Cl.: H01L 25/18, H01L 25/065

(54) **A three-dimensional electronics package**

(30) Priority: 25.03.2009 US 211004 P
(71) Applicant: LSI Corporation, Milpitas, CA 95035 (US)
(72) Inventor: Burleson, Jeffrey P., Fort Collings, CO 80526 (US); Moinian, Shahriar, New Providence, NJ 07974 (US); Osenbach, John, Kutztown, PA 19530 (US); Pallinti, Jayanthi, San Jose, CA 95131 (US)
(74) Representative: Williams, David John

(57) **Abstract**

An electronics package 100 comprising a substrate 105 having a planar surface 107, a memory die 110 and a logic die 120. Memory circuit components 112 interconnected to memory die contacts 114 located on an outer surface 116 of a face 118 of the memory die. Logic circuit components 122 interconnected to logic die contacts 124 located on an outer surface 126 of a face 128 of the logic die. Memory die contacts and the logic die contacts are interconnected such that the face of the memory die opposes the face of the logic die. A plurality of bonds 130 interconnect input-output contacts 132 on the planar surface of the substrate, to external die contacts 135 on one of the face of the logic die or the face of the memory die. One face opposes the planar surface, the other face is not directly connected to the interconnect input-output contacts.

## Description

### CROSS-REFERENCE TO RELATED APPLICATION

This application claims the benefit of U.S. Provisional Application Serial No. 61/211,004, filed by Burleson et al. on March 25, 2009, entitled, "Micromachined Si interposer for 3D packaging," commonly assigned with this application, and incorporated in its entirety herein.

### TECHNICAL FIELD

This application is directed, in general, integrated circuits and, more specifically, to three-dimensional integrated circuit packages.

### BACKGROUND

The electronics revolution has been fueled by transitory scaling as the technology migrated from tens of micron dimensions to sub-tenths of micron dimensions and is aimed at sub-hundredths of micron dimensions. Although digital logic continues to benefit from technology scaling, other circuit blocks such as analog, memory, and input/output (i/o) blocks may not scale down as well or as fast. Furthermore, the physical limitations of atoms and the wavelength of light are beginning to be impinged upon. Thus the cost/performance curve that has been the basis of Moore's law is beginning to stall. Alternative procedures may facilitate continuation of this cost/performance curve.

### SUMMARY

To address the deficiencies of the prior art, the present disclosure provides, in one embodiment, an electronics package. The package comprises a substrate having a planar surface, a memory die and a logic die. The memory die has memory circuit components, the memory circuit components interconnected to memory die contacts located on an outer surface of a face of the memory die. The logic die has logic circuit components, the logic circuit components interconnected to logic die contacts located on an outer surface of a face of the logic die. The memory die contacts and the logic die contacts are interconnected such that the face of the memory die opposes the face of the logic die. The electronics package also comprises a plurality of bonds that interconnect input-output contacts on the planar surface of the substrate, to external die contacts on one of the face of the logic die or the face of the memory die. The one face of the logic or memory die opposes the planar surface and the other of the logic die face or said memory die face is not directly connected to the interconnect input-output contacts.

Another embodiment is a method of manufacturing an electronics package. The method comprises providing a memory die, and providing a logic die. The memory die has memory circuit components, the memory circuit components interconnected to memory die contacts located on an outer surface of a face of the memory die. The logic die has logic circuit components, the logic circuit components interconnected to logic die contacts located on an outer surface of a face of the logic die. The method also comprises interconnecting the memory die contacts and the logic die contacts such that the face of the memory die opposes the face of the logic die. The method further comprises interconnecting input-output contacts on a planar surface of a substrate to external die contacts on one of the face of the logic die or the face of the memory die, wherein the one face of the logic or memory die opposes the planar surface and the other of the logic die face or the memory die face is not directly connected to the interconnect input-output contacts.

### BRIEF DESCRIPTION

For a more complete understanding of the present invention, reference is now made to the following descriptions taken in conjunction with the accompanying drawings, in which:
FIG. 1A presents a cross-sectional view of a portion of an example electronics package of the disclosure;
FIG. 1B shows a detailed cross-sectional view of a portion of an example electronics package corresponding to view B in FIG. 1A;
FIG. 1C shows a detailed plan view of a portion of an example electronics package corresponding to view line C-C in FIG. 1A;
FIG. 2 presents a cross-sectional view of another example electronics package of the disclosure;
FIG. 3 presents a cross-sectional view of another example electronics package of the disclosure; and
FIG. 4 presents a flow diagram illustrating selective steps in an example embodiment of a method of manufacturing an electronics package of the disclosure, such as the electronics packages illustrated in FIGs. 1A-3.

### DETAILED DESCRIPTION

Embodiments of the present disclosure replace traditional two-dimensional horizontally interconnected logic and memory dies in favor of a three-dimensional vertically interconnected configuration. In particular, electronic packages of the present disclosure benefit from the use of three-dimensional stacked die configurations with an active face-to-active face vertical interconnection between memory and logic dies, in combination with one of the die faces having direct straight-line bonds to i/o contacts on the surface of the substrate opposing that face. This combination can provide a high density of short high-speed interconnections between dies and between the vertical stack of dies and the substrate.

Such package configurations are in contrast to electronic package configurations where logic and memory dies are configured side-by-side, where vertically stacked dies are connected back to front, or, where dies are connected face-to-face but then a back end of one die is used for connection to a substrate. All of these configurations are rejected because they have longer-than-desired interconnections between the logic and memory dies or between the dies and the substrate.

As part of the present disclosure, it was recognized that to provide a high density interconnections without sacrificing interconnection speed, it is very important to minimize the length of the bond interconnecting the i/o contacts on the substrate and the contacts on the face of the one die that is interconnected to the substrate. In particular, the length of the bond between the substrate and the die face was recognized, as part of the present disclosure, as a new result-effective variable that controls the speed and density of communications between the vertically stacked dies the substrate.

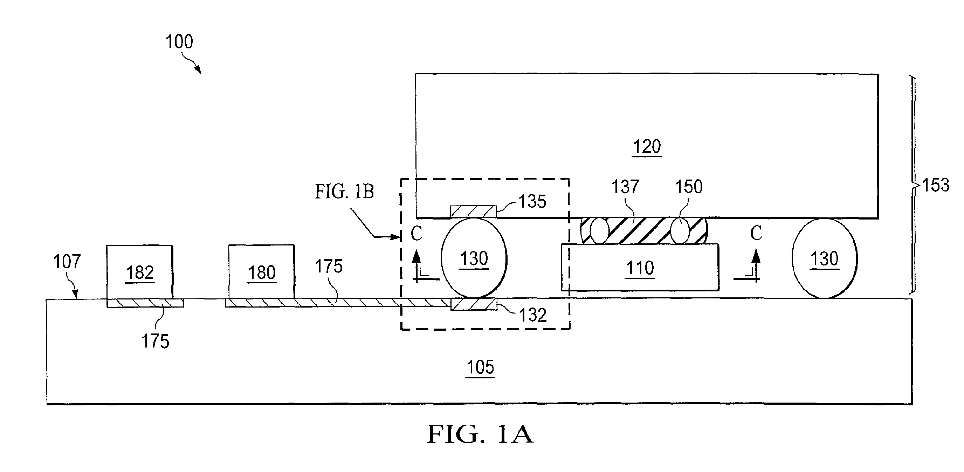

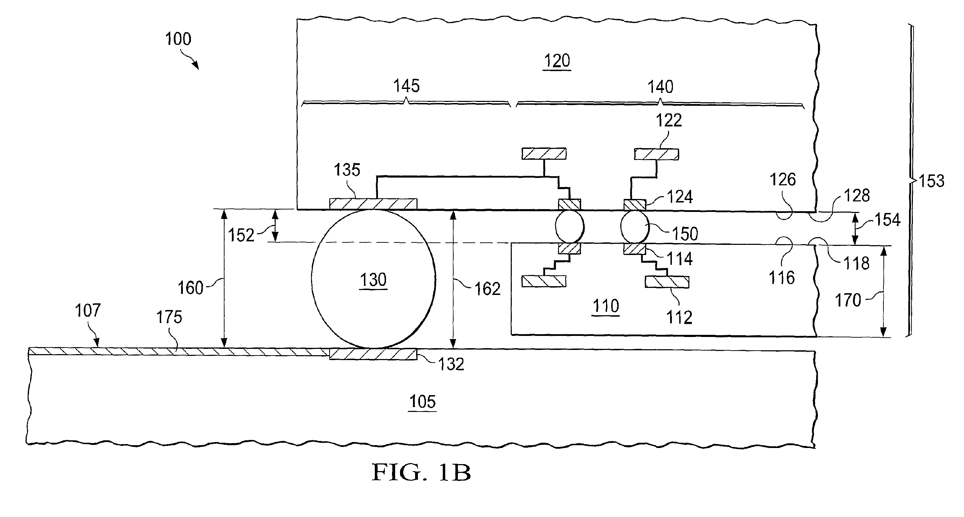

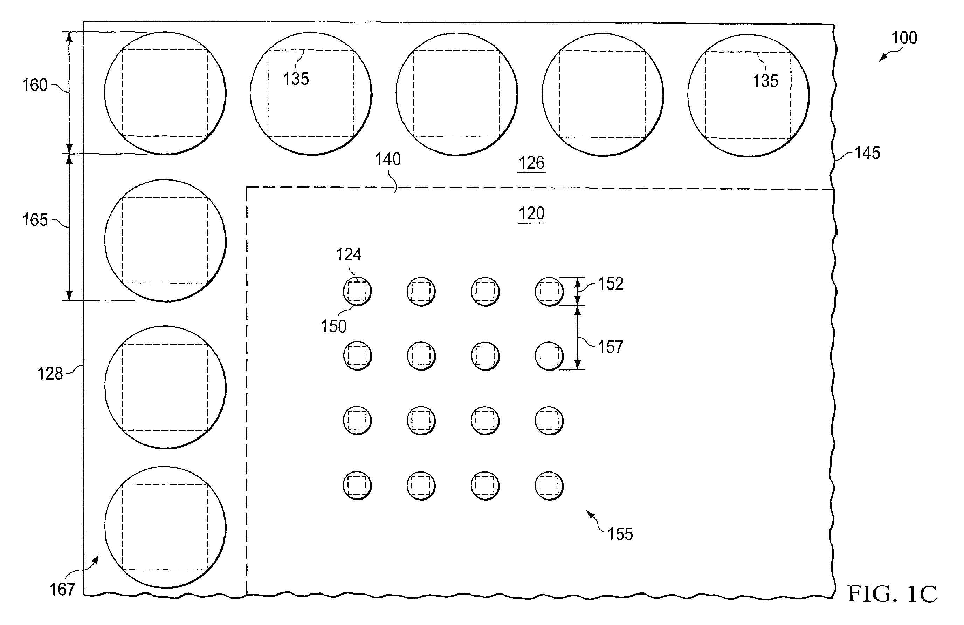

One embodiment of the disclosure is an electronics package. FIG. 1A presents a cross-sectional view of a portion of an example electronics package 100 of the disclosure. FIG. 1B shows a detailed cross-sectional view B of an example package 100 corresponding to view B in FIG. 1A. FIG. 1C shows a plan view of a portion of an example electronics package corresponding to view line C-C in FIG. 1A.

With continuing reference to FIGs 1A-1C, the package 100 comprises a substrate 105 having a planar surface 107. The package 100 also comprises a memory die 110. The memory die 110 has memory circuit components 112 (e.g., SRAM or DRAM memory integrated circuits), the memory circuit components 112 being interconnected to memory die contacts 114 located on an outer surface 116 of a face 118 of the memory die 110. The package 100 also comprises a logic die 120. The logic die 120 has logic circuit components 122, the logic circuit components 122 (e.g., CMOS or bi-CMOS logic integrated circuits) being interconnected to logic die contacts 124 located on an outer surface 126 of a face 128 of the logic die 120. As further illustrated in the detailed view presented in FIG. 1B, the memory die contacts 114 and the logic die contacts 124 are interconnected such that the face 118 of the memory die 110 opposes the face 128 of the logic die 120.

The faces 118, 128 of the memory and logic dies 110, 120 can be referred to as active (e.g., active face 118 or active face 128) because the circuit components 112, 122 are routed to their respective surfaces 116, 126.

Additionally, the package 100 comprises a plurality of bonds 130 that interconnect input-output contacts 132, located on the planar surface 107 of the substrate 105, to external die contacts 135 located on one of the face 128 of logic die 120, or, the face 118 of the memory die 110, such that the one face 118 or face 128 (e.g., face 128 in the examples shown in FIGs 1A-1B), opposes the planar surface 107. As further illustrated, the other face (e.g., face 118 in the examples shown in FIGs 1A-1B) is not directly connected to the interconnect input-output contacts 132. For instance, there are no lengthy wire bonds, or lengthy through-holes passing through the die 110, to directly connect the active face 118 of the memory die 110 to the input-output contacts 132. The bonds 130 can be composed of any electrically conductive material. Some embodiments of the bonds 130 include metals or metal alloys that facilitate the rapid formation of low resistance, mechanically strong interconnections. For instance, the bonds 130 can be composed of metals such as copper, gold, solder (e.g., tin solder or tin-gold alloy solder, or other metal alloys) which are conducive to reflow bonds, compression bonds or thermo-compression bonds. For instance, in some preferred embodiments, the bonds 130 can include a compression bond, a reflow bond or a thermocompression bond composed of a metal bilayer (e.g., a gold-gold or copper-copper bilayer) or metal trilayer (e.g., a copper-solder-copper trilayer).

As further illustrated in FIG. 1A, in some cases to improve the mechanical stability of the face-to-face interconnection between the pair of dies 110, 120, a dielectric material 137 can be placed between memory die 110 and the logic die 120. For instance, a polymer dielectric material 137, such as an epoxy polymer, can fill the space between the dies 110, 120.

For the particular configuration depicted in FIGs. 1A and 1B, external die contacts 135 on the face 128 of logic die 120 are interconnected to the input-output contacts 132. In other embodiments, however, the positions of the memory die 110 and logic die 120 could be reversed as compared to the embodiments depicted in FIGS. 1A and 1B. In such cases, external contacts on the face of memory die would be interconnected to the input-output contacts 132 of the substrate 105 and the face 118 of the memory die 110 having the external contacts would be opposed to the planar surface 107 and the other face 128 of the logic die 120 is not directly connected to the interconnect input-output contacts 135 (not shown).

As further illustrated in FIGs. 1A and 1B, in some embodiments, the face 128 of the logic die 120 can be larger than face 118 of the memory die 110. Have a larger face 128 as compared to the face 118 facilitates providing locations for the external die contacts 135 which can be directly connected to the input-output contacts 132 in a straight-line, and thereby provide the shortest path between the input-output contacts 132 and the external die contacts 135. As illustrated in FIG. 1B and 1C, the memory die 110 can be interconnected to a central portion 140 of the face 128 of the logic die 120, and the external contacts 135 can be located in a perimeter portion 145 of the face 128. In some cases, such as shown in FIG. 1C for instance, the external die contacts 135 can surround the die contacts 124 on the logic die surface 126. In other embodiments however (not shown), the memory die 110 can be interconnected to a non-central portion of the logic die 120, and, the external die contacts 135 need not surround the die contacts 124.

In still other embodiments, such as when the positions of the memory die 110 and logic die 120 are reversed, e.g., as compared to that depicted in FIGS. 1A and 1B, it can be advantageous for the face 118 of the memory die 110 to be larger than the face 128 of the logic die 120 (not shown). In such embodiments, the external contacts 135 can be located on a perimeter region of the face 118 of the memory die 110, and, the logic die 120 can be interconnected to a central portion of the memory die 110 (not shown). In other embodiments, however (not shown), the one die (e.g., logic die 120) can be interconnected to a non-central portion of the memory die 110, and, the external die contacts 135 need not surround the die contacts 114 on the memory die surface 116.

As illustrated in the detailed cross-sectional view presented in FIG. 1B, in some embodiments, the interconnection between the memory die contacts 114 and the logic die contacts 124 includes micro-bonds 150 having a diameter 152 of about 100 microns or less, and preferably 50 microns or less, and more preferably in a range from 25 to 10 microns. The diameter 152 refers to a deformed micro-bond 150 after the dies 110, 120 are interconnected (e.g., a distance after a reflow or compression process to form the micro-bond 150). The micro-bonds 150 can be composed of the same material and formed in the same fashion as discussed for the bond 130.

When the dies 110, 120 are interconnected to form a vertical stack 153, the micro-bond's diameters 152 are equal to the gap distance 154 between the face 118 of the memory die 110 and the face 128 of the logic die 120. It is preferable to interconnect the dies 110, 120 using micro-bonds 150 because these short-length bonds allow configurations with a high number of interconnects per unit area (e.g., a high interconnect density). Smaller diameter 152 micro-bonds 150 are also preferred because the resulting smaller gap 154 between the memory die face 118 and logic die face 128, facilitates a faster communication of information between the memory die 110 and logic die 120, because the distance for an electrical signal to travel between the dies 110, 120 is shorter.

As illustrated in the detailed plan view presented in FIG. 1C, in some embodiments, the micro-bonds 150 are laid out in an array 155 (e.g., a 1-dimensional or 2-dimensional array) having a pitch 157 between adjacent micro-bonds 150 of about 200 microns or less. As shown in FIG. 1C, the pitch 157 refers to the edge-to-edge distance between adjacent micro-bonds 150 after the dies 110, 120 are interconnected (e.g., a distance after a reflow or compression process to form the micro-bond 150). In some embodiments, it is desirable to maximize the number of interconnections between the components 112, 122 of the two dies 110, 120. Such embodiments are facilitated by increasing the number of memory die contacts 114 and logic die contacts 124 per unit area (e.g., to increase the interconnect density) on the respective faces 118, 128 of the dies 110, 120, with the micro-bonds 150 there between to make the interconnection. Increasing the interconnect density, in turn, can be facilitated by reducing the pitch 157 between adjacent micro-bonds 150 which, in turn, can be facilitated by reducing the diameters 152 of micro-bonds 150. In some embodiments, it is preferable for the pitch 157 to equal about two times the diameter 152 to facilitate having the shortest distance between contacts 114, 124 while at the same time ensuring electrical isolation between adjacent micro-bonds 150.

The size of the micro-bond 150 interconnecting pairs of die contacts 118, 128, which is equal to the diameter 152, is an important variable which controls the maximum density interconnections that are possible between the dies 110, 120 as well as the speed of communication between individual pairs of contacts 118, 128. For example, if the desired number of interconnections per square millimeter equals about 400, then the desired pitch 157 equals about 50 microns, and therefore the desired micro-bond diameter 152 equals about 25 microns or less. For example, if the desired number of interconnections per square millimeter equals about 1000, then the desired pitch 157 equals about 30 microns, and therefore the desired micro-bond diameter 152 equals about 15 microns or less.

Similarly, the size of the bond 130 interconnecting the i/o contacts 132 and external die contacts 135 can be an important variable controlling the maximum density of interconnections that are possible between the vertical stack of dies 153 and substrate 105 as well as the speed of communication between individual pairs of contacts 132, 135. As further illustrated in FIGs. 1B and 1C, embodiments of the bonds 130 that interconnect the input-output contacts 132 and external contacts 135 can have a diameter 160 of about 400 microns or less, and more preferably about 100 microns or less and even more preferably about 50 microns or less. In such embodiments, the gap distance 162 between the external contacts 135 and the input-output contacts 132 is equal to the diameters 160 of the bonds 130. In some embodiments, it is preferable for the pitch 165 between adjacent bonds 130 to equal about two times the diameter 160 to ensure the shortest distance between contacts 132, 135 while at the same time ensuring electrical isolation between adjacent bonds 130. As shown in FIG. 1C, the pitch 165 refers to the edge-to-edge distance between adjacent bonds 130 after the bonds 130 are formed between the input-output contacts 132 and external contacts 135 (e.g., a distance after a reflow or compression process to form the bond 130). For instance, in some cases, the external contacts 135 can have a pitch 165 between adjacent bonds 130 equal to about 800 microns or less, and more preferably about 400 microns or less, and even more preferably about 200 microns or less, with a corresponding possible increase in the interconnect density.

For example, in some embodiments, bonds 130 interconnecting the input-output contacts 132 and external die contacts 135 can be laid out in an array 167 (e.g., 1-dimensional or 2-dimensional array) having a pitch 165 between adjacent bonds 130 of about 200 microns or less. In such cases, the diameter 160 of the bonds 130 is preferably about 100 microns or less, which in turn, is equal to the gap 162 between the input-output contacts 132 and external contacts 135. For instance, in embodiments where the pitch 165 equals about 50 microns, the number of interconnections per square millimeter equals about 400, and at a pitch 165 of about 30 microns, the interconnections per square millimeter equals about 1000. The diameter 160 refers to a deformed bond 160 after the one die (e.g., one of the dies 110, 120) are interconnected to the input-output contacts 132 (e.g., a distance after a reflow or compression process to form the bond 160).

In some configurations of the package 100, the presence of the other die that is located between the die that is interconnected to the substrate, can interfere with the goals of having a high density of interconnections and/or short interconnection lengths. For instance, for the package 100 configuration depicted in FIG. 1A or 1B, the memory die 110 is located between the logic die 120 and the substrate 105. Consequently, the memory die's thickness 170 (e.g., 150 microns in some cases) can physically interfere with a goal of minimizing the length of the interconnection, because the diameters 160 of the bonds 130 must be large enough to bridge the gap 162 between the i/o contacts 132 and the external contacts 135 on the face 128 of the logic die 120.

Accordingly, in some embodiments, it can be advantageous to reduce the memory die's thickness 170 because this helps to minimize the gap 162 that the bonds 130 have to bridge. For instance, in some embodiments, the memory die's thickness 170 can equal about 50 microns or less, and more preferably about 10 microns. In other package configurations, where the positions of the memory die 110 and logic die 120 are reversed (not shown), the thickness of the logic die could have a similar reduced thickness.

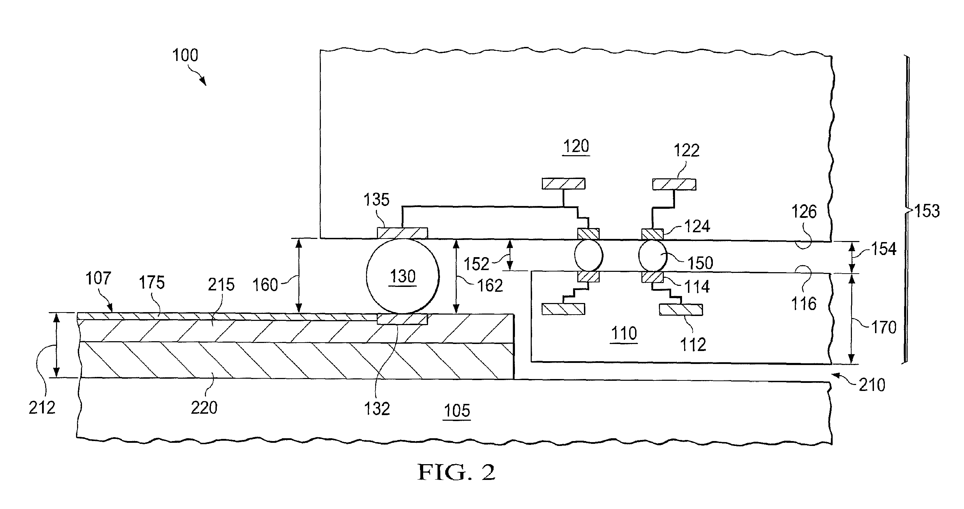

In still other embodiments, the location of one of the dies in a substrate cavity can help to minimize the distance separating the contacts on the substrate and die. An example of such an embodiment in illustrated in FIG. 2, which presents a cross-sectional view, analogous to FIG. 1B, of another example electronics package 100 of the disclosure.

As shown in FIG. 2, the other one of the memory die 110 or the logic die 120 that is not directly interconnected to the input-output contacts 132 (e.g., the memory die 110 in this example) can be located substantially in a cavity 210 of the substrate 105. Accordingly, the gap 162 that the bonds 130 have to traverse is reduced as compared to the embodiment shown in FIG. 1B. As further illustrated in FIG. 2, the cavity 210 has a depth 212 that is greater than the portion of the thickness 170 of the one memory die 110 (or logic die, in other cases) that is located substantially within the cavity 210 of sufficient depth 212 that the memory die 110 does not directly contact the substrate 105. This can be advantageous because it avoids mechanical stress and damage to the bonds 130, micro-bonds 150 or dies 110, 120 when the dies 110, 120 are mounted to the substrate 105.

In some cases, achieving the desired density of i/o contacts 132 on the package substrate 105 may be difficult to achieve, e.g., because of the thickness of one of the dies (e.g., the the thickness 170 of the memory die 110 in FIG 1A), or, because a desired fine pitch (e.g., a pitch of 20 micron or smaller) of i/o contacts 132 is difficult to form on certain types of substrate 105 using available procedures (e.g., certain printed circuit board package substrates). In such cases, it can be advantageous for the package to further include an interposer body located between the pair of dies 110, 120 and substrate 105. The term interposer body as used herein refers to a semiconductor layer or multi-layer, upon which a high pitch of contacts can be formed, e.g., because high resolution photolithographic and etching procedures are available for use on the particular substrate being used (e.g., a silicon substrate.

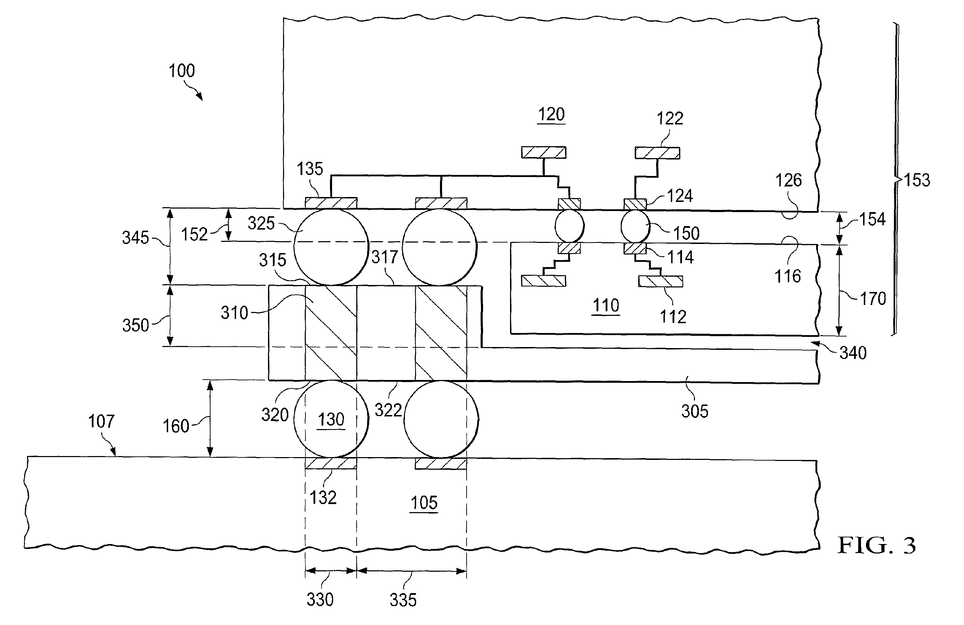

An example of such an embodiment is illustrated in FIG. 3, which presents a cross-sectional view, analogous to FIG. 1B, of another example electronics package 100 of the disclosure. The package 100 further includes an interposer body 305 having through-body-vias 310. In some preferred embodiments, the interposer body 305 can be composed of silicon, or other semiconductor material, that is conducive to defining a high density of through-body-vias 310. The through-body-vias 310 have first ends 315 that terminate at a first side 317 of the interposer body 310, and second opposite ends 320 that terminate at a second side 322 of the interposer body 305. The ends 315, 320 of the through-body-vias 310 serve as interior contacts for the interconnection between the substrate 105 and the vertical stack of dies 153. For instance, the first ends 315 of the through-body-vias 310 can be interconnected to the external die contacts 135 on the logic die 120 (or memory die 110 in other embodiments). The second ends 320 of the through-body-vias 310 can be connected to the bonds 130 that contact the i/o contacts 132 on the substrate 105. The first ends 315 of the through-body-vias 310 and the external die contacts 135 can be interconnected with bonds 325 that are composed of the same materials, and configured to have similar sizes, as previously discussed for the bonds 130 that contact the i/o contacts 132 on the substrate 105.

The use of an interposer body 305 of the present disclosure is in contrast to electronic packages where logic and memory dies are interconnected in a horizontally configuration on an interposer, or, where dies are vertically interconnected through an interposer that is located in between the dies. A problem with such package configurations is that they can introduce timing delays between die-to-die contacts or die-to-i/o contacts due to the presence of long horizontal or vertical routing traces in or on the interposer body.

In some embodiments, the through-body-vias 310 have a diameter 330 of about 50 microns or less, which in turn, can provide a pitch 335 of through-body-vias 310 of about 100 microns or less. In some cases, the diameter 330 is in a range of about 40 to 5 microns, providing a corresponding pitch 335 in a range of about 80 microns to 10 microns, respectively. In some cases, a density of the through-body-vias 310 corresponds to at least about 300 per square millimeter of the sides 317, 322 of the interposer body 310.

As further illustrated in FIG. 3, in some embodiments, the interposer body 305 can have a cavity 340. Similar to that discussed in the context of FIG. 2 for the substrate cavity 210, the interposer cavity 340 can reduce the gap distance 345, and hence interconnection distance, between the first ends 315 of the through-body-vias 310 and the external die contacts 135. For instance, the other one of the memory or logic dies 110, 120 that is not directly interconnected to the first ends 315 of the through-body-vias 310 (e.g., the memory die 110 as shown in FIG. 3), can be located substantially in the interposer cavity 320. The interposer cavity 340 can have a depth 350 that is greater than the portion of the thickness of the memory or logic die 110, 120 (e.g., the portion of the memory die thickness 170) that is located substantially in the cavity 340.

Embodiments of the package, such as the example packages depicted in FIGs. 1A-3, could include any number of other components to complete the package. For instance, in some embodiments, such as shown in FIG. 1A, the i/o contacts 132 on the planar surface 107 could be connected via conductive traces 175 to one or more other electrical component 180 (e.g., a power supply, electrical ground) and/or to external connections 182 located on or in the substrate 105. In view of the disclosure, one skilled in the art would be familiar with the other types of components the package 100 could include. In some embodiments the package 100 can be configured as a application specific integrated circuit (ASIC) for use in memory and computation intensive applications in telecommunication devices.

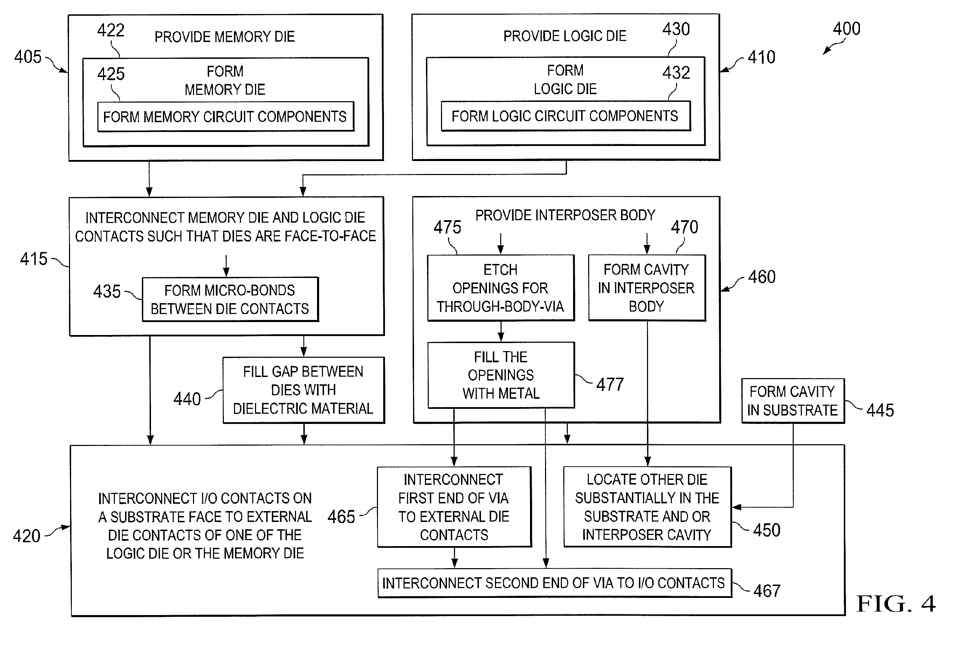

Another embodiment is a method of manufacturing an electronics package. FIG. 4 presents a flow diagram illustrating selective steps in an example embodiment of a method 400 of manufacturing an electronics package of the disclosure, such as any of the electronics packages illustrated in FIGs. 1A-3.

With continuing reference to FIGs. 1A-3, the method 400 comprises a step 405 of providing a memory die 110. The memory die 110 has memory circuit components 112 interconnected to memory die contacts 114 located on the outer surface 116 of the face 118 of the memory die 110. The method 400 also comprises a step 410 of providing a logic die 120. The logic die 120 has memory circuit components 122 interconnected to logic die contacts 124 located on the outer surface 126 of the face 128 of the memory die 110. The method 400 further comprises a step 415 of interconnecting the memory die contacts 114 and the logic die contacts 124 such that the face 118 of the memory die 110 opposes the face 128 of the logic die 120. The method 400 still further includes a step 420 of interconnecting i/o contacts 132 on the planar surface 107 of the substrate 105 to external die contacts 135 on one of the face 128 of the logic die 120 or the face 118 of the memory die 110. That one memory die face 118 or logic die face 128 opposes the planar surface 107 of the substrate 105 and the other of said logic die face 128 or memory die face 118 is not directly connected to the interconnect input-output contacts 135.

In some embodiments of the method 400, providing the memory die in step 405 includes a step 422 of forming the memory die 110, which in turn, can include a step 425 of forming the memory circuit components 112 on or in the face 118 of the memory die 110. Similarly, providing the logic die (step 410), can include a step 430 of forming the logic die 120, which in turn, can include a step 432 of forming the logic circuit components 122 on or in the face 128 of the logic die 120.

One skilled in the art would be familiar with the standard procedures in the semiconductor industry, which can be used as part of steps 422-432, in the manufacture of memory circuit and logic circuits in or on the dies, the formation of interlayer metal and dielectric layers, and, the formation of surface contacts on the dies (e.g., memory die contacts 114, logic die contacts 124, and external die contacts 135) to facilitate interconnection with other components outside of the die. The contacts 114, 124 can be formed so as to have the desired pitch (e.g., equal to the pitch 157 between micro-bonds 150) to facilitate forming the desired number of die-to-die interconnections per square millimeter, such as previously discussed in the context of FIGs. 1A-1C.

In some embodiments of the method 400, interconnecting the memory die contacts 114 and the logic die contacts 124 in step 415 can include a step 435 of forming micro-bonds 150 between the contacts 114, 124. The micro-bonds 150 can be formed to have the desired diameter 152 and pitch 155 to facilitate forming the desired number of die-to-die interconnections per square millimeter, such as previously discussed in the context of FIGs. 1A-1C.

In some cases, flip-chip bonding can be used to form the micro-bonds 150 as part of step 435. One skilled in the art would be familiar with the procedures, as part of step 435, to perform flip-chip bonding, including forming alignment structures on the faces 118, 128 of memory and logic dies 110, 120, to facilitate the proper alignment of the memory die contacts 114 with the logic die contacts 124. One skilled in the art would be familiar with procedures, also as part of step 415, to use micro-manipulators to flip one die onto the other die, and, to form the micro-bonds 150, e.g., by solder ball bonding, compression bonding, reflow bonding or thermocompression bonding.

In some embodiments of the method 400, interconnecting the input-output contacts 132 to the external die contacts 135 in step 420 can include forming bonds 130 between the contacts 132, 135. For instance, flip-chip bonding, similar to that described in the context of step 415, can be used as part of step 420 to form the bonds 130, e.g., such that solder balls, compression bonds, reflow bond or thermocompression bonds directly touch the contacts 132, 135.

Some embodiments of the method 400 further include a step 440 of filling a gap 154 between the memory die 110 and the logic die 120 with a dielectric material 137. In some preferred embodiments step 440 is conducted after the dies 110, 120 are interconnected in step 415. For instance, as part of step 440, a sufficient amount of dielectric material 137 such as an epoxy polymer, in liquid form, can be introduced into the gap 154 and then cured to form a solid polymer such that the memory die 110 and logic die 120 are at least in part held together by the dielectric material 137. In different embodiments, the dielectric material 137 can partially fill, or, entirely fill the gap 154.

Some embodiments of the method 400 further include a step 445 of forming a cavity 210 in the substrate 105. For instance, a portion of the substrate 105 at the planar surface 107 of the substrate 105 can be micromachined to form the cavity 210. Or in other embodiments, the cavity 210 could be formed in step 445 using wet chemical etching, plasma etching, or reactive ion etching processes to remove a portion of the substrate 105, such as a semiconductor substrate (e.g., a silicon substrate). In still other embodiments, such as when the substrate 105 includes a multilayered package substrate, portions of different layers 215, 220 (e.g., a solder mask layer 215 and metal layer 220 in the embodiment shown in FIG. 2) can be removed in step 445 as part of photolithography and etching procedures used to define conductive traces 175 and i/o contacts 132 on the planar surface 107 of the substrate 105.

In cases whether there is a cavity 210 is formed in the substrate 105, the interconnecting step 420 can further include a step 450 of locating the other one of the memory die 110 or the logic die 120 (e.g., the memory die 110 for the embodiment shown in FIG. 2) that is not directly interconnected to the input-output contacts 132, to be substantially in the cavity 210. As noted above in the context of FIG. 2, this can beneficially reduce the size of the bond 130 required to interconnect the input-output contacts 132 and external die contacts 135.

Some embodiments of the method 400 further include a step 460 of providing an interposer body 305. As previously discussed in the context of FIG. 3, the body 305 has through-body-vias 310 with first ends 315 that terminate at a first side 317, and, second opposite ends 320 that terminate at a second side 322 of the body 305. In such embodiments, the step of 420 interconnecting the input-output contacts 352 can further include a step 465 of interconnecting the first ends 315 of the through-body-vias 315 to the external die contacts 135 on one of the logic or memory dies 110, 120 (e.g., the logic die 120 in FIG. 3). In such embodiments, the step of 420 interconnecting the input-output contacts 352 can also include a step 467 of interconnecting the second ends 320 of the through-body-vias 310 to the i/o contacts 132 on the planar surface 107 of the substrate 105, to complete the interconnection between the i/o contacts 132 and the external die contacts 135 on the face 128 of the die 120 (FIG. 3). For example, step 467 can include flip-chip bonding the substrate 105 and the interposer body 305 together such that a plurality of bonds 130 (FIG. 3) directly contact discrete pairs of input-output contacts 132 and second ends 320 of the through-body-vias 310.

Some embodiments of the method 400 further include a step 470 of forming a cavity 340 in the interposer body 305 provided in step 440. The interposer cavity 340 can be formed by the same types of processes described for the formation of the substrate cavity 210 in step 445. In such embodiment, where a cavity 340 is formed in the interposer body 305, the step 420 of interconnecting the i/o contacts 132 and external die contacts 135 can include the step 450 of locating the other one of the memory die 110 or the logic die 120 that is not directly interconnected to the input-output contacts 132 (e.g., the memory die 110 shown in FIG. 3) to be substantially in the interposer cavity 340.

In some embodiments, providing the interposer body 305 in step 465 further includes a step 475 includes etching a semiconductor layer 360 (e.g., a silicon layer) to form openings 365 through the semiconductor layer 360 for the through-body-vias 310. In preferred embodiments, where it is desirable to have a high density of interconnections to one of the dies 110, 120, the via openings 365 have a diameter 330 of 50 microns or less and a pitch 335 of about 100 microns or less. The via openings 365 can be filled with a metal (e.g., copper) in a step 477 using conventional chemical physical or vapor deposition or electrochemical deposition procedures.

Those skilled in the art to which this application relates will appreciate that other and further additions, deletions, substitutions and modifications may be made to the described embodiments.

## Claims

1. An electronics package, comprising:
a substrate having a planar surface;
a memory die having memory circuit components, said memory circuit components interconnected to memory die contacts located on an outer surface of a face of said memory die;
a logic die having logic circuit components, said logic circuit components interconnected to logic die contacts located on an outer surface of a face of said logic die, wherein said memory die contacts and said logic die contacts are interconnected such that said face of said memory die opposes said face of said logic die; and
a plurality of bonds that interconnect input-output contacts on said planar surface of said substrate to external die contacts on one of said face of said logic die or said face of said memory die, wherein said one logic die face or said memory die face opposes said planar surface and wherein the other of said logic die face or said memory die face is not directly connected to said interconnect input-output contacts.

2. The package of claim 1, wherein said memory die is interconnected to a central portion of said logic die and said external die contacts are located on a perimeter portion of said outer surface of said face of said logic die.

3. The package of claim 1, wherein the other one of said memory die or said logic die that is not interconnected to said input-output contacts is located substantially in a cavity of said substrate.

4. The package of claim 1, further including an interposer body having through-body-vias with first ends that terminate at a first side of said interposer body and second opposite ends that terminate at a second side of said interposer body, wherein said first ends of said through-body-vias are interconnected to said external die contacts on said one of said logic die or said memory die, and
said second ends of said through-body-vias are connected to said bonds.

5. The package of claim 4, wherein the other one of said memory die or said logic die that is not interconnected to said first ends of said through-body-vias is located substantially in a cavity of said interposer body.

6. The package of claim 1, wherein said input-output contacts on said planar surface of said substrate are electrically coupled by conductive traces to one or more electrical components or external connections on or in said substrate.

7. A method of manufacturing an electronics package, comprising,
providing a memory die, said memory die having memory circuit components, said memory circuit components interconnected to memory die contacts located on an outer surface of a face of said memory die;
providing a logic die, said logic die having logic circuit components, said logic components interconnected to logic die contacts located on an outer surface of a face of said logic die;
interconnecting said memory die contacts and said logic die contacts such that said face of said memory die opposes said face of said logic die; and
interconnecting input-output contacts on a planar surface of a substrate to external die contacts on one of said face of said logic die or said face of said memory die, wherein said one logic die face or said memory die face opposes said planar surface and wherein the other of said logic die face or said memory die face is not directly connected to said interconnect input-output contacts.

8. The method of claim 7, further including forming a cavity in said substrate and said interconnecting further includes locating the other one of said memory die or said logic die that is not interconnected to said input-output contacts to be substantially in said cavity.

9. The method of claim 7, further including:
providing an interposer body having through-body-vias with first ends that terminate at a first side of said interposer body and second opposite ends that terminate at a second side of said interposer body;
interconnecting said first ends of said through-body-vias to said external die contacts on said one logic die or memory die; and
said interconnecting said input-output contacts to said second ends of said through-body-vias.

10. The method of claim 9, further including forming a cavity in said interposer body and said interconnecting said first ends of said through-body-vias to said external die contacts, includes locating the other one of said memory die or said logic die that is not interconnected to said input-output contacts to be substantially in said interposer cavity.
